(19) Europäisches Patentamt / European Patent Office / Office européen des brevets

(11) **EP 2 930 834 B1**

## (12) EUROPEAN PATENT SPECIFICATION

(45) Date of publication and mention
of the grant of the patent:
**13.09.2017 Bulletin 2017/37**

(51) Int Cl.:
**H02M 3/155** $^{(2006.01)}$  **G05F 1/46** $^{(2006.01)}$
**H02M 3/156** $^{(2006.01)}$  **H02M 1/00** $^{(2007.01)}$

(21) Application number: **15160483.2**

(22) Date of filing: **24.03.2015**

(54) **METHOD AND APPARATUS FOR DETERMINING RESISTANCE VALUES OF DYNAMIC VOLTAGE-ADJUSTING CIRCUIT**

VERFAHREN UND VORRICHTUNG ZUR BESTIMMUNG DER WIDERSTANDSWERTE DYNAMISCHER SPANNUNGSANPASSUNGSSCHALTUNGEN

PROCÉDÉ ET APPAREIL PERMETTANT DE DÉTERMINER LES VALEURS DE RÉSISTANCE DE CIRCUIT DE RÉGLAGE DE TENSION DYNAMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2014 CN 201410117739**

(43) Date of publication of application:
**14.10.2015 Bulletin 2015/42**

(73) Proprietor: **Huawei Technologies Co., Ltd.
Longgang District
Shenzhen, Guangdong 518129 (CN)**

(72) Inventors:
- **ZHANG, Bingfeng**
  **Shenzhen, Guangdong 518129 (CN)**
- **CHEN, Yuzhu**
  **Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
**CN-A- 102 931 842      US-A1- 2007 090 819**

- **BUIATTI G M ET AL: "An unified method for estimating the parameters of non-isolated DC/DC converters using continuous time models", TELECOMMUNICATIONS ENERGY CONFERENCE, 2007. INTELEC 2007. 29TH INTERNATIONAL, IEEE, PISCATAWAY, NJ, USA, 30 September 2007 (2007-09-30), pages 334-341, XP031228862, ISBN: 978-1-4244-1627-1**

**Description**

**TECHNICAL FIELD**

The present application relates to the field of electronic technologies, and in particular, to a method and apparatus for determining resistance values of a dynamic voltage-adjusting circuit.

**BACKGROUND**

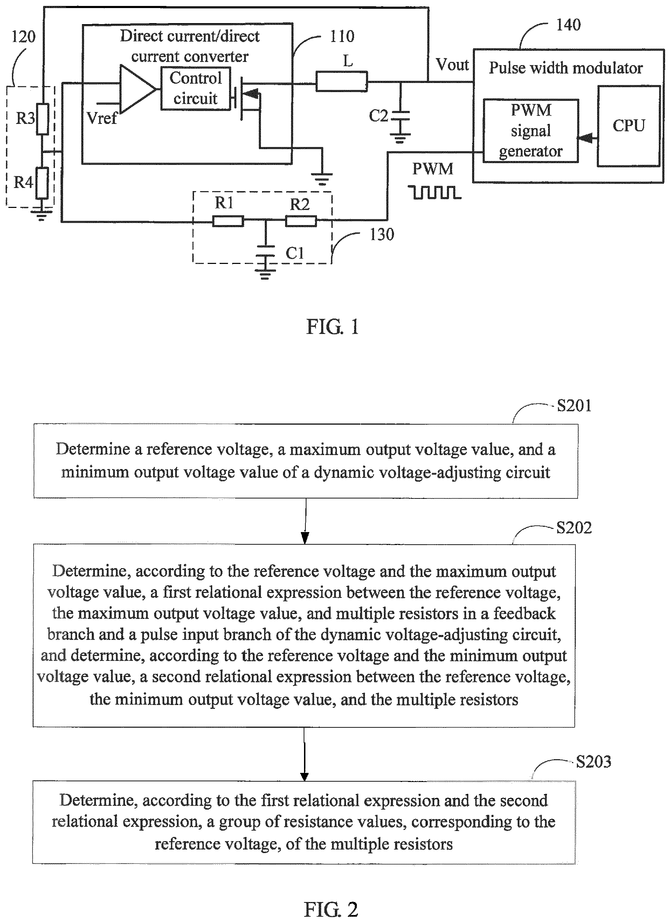

In the prior art, Pulse width modulation (PWM) is a common means to dynamically adjusting voltage. As shown in FIG 1, the prior art provides a dynamic voltage-adjusting circuit, which includes a direct current/direct current converter 110, a feedback branch 120, a pulse input branch 130 and a pulse width modulator 140. A first input end of the direct current/direct current converter 110 is configured to input a reference voltage Vref; a second input end of the direct current/direct current converter 110 is configured to receive a voltage fed back through the feedback branch 120 and a pulse voltage Vpwm input by the pulse width modulator 140 through the pulse input branch 130; and an output end of the direct current/direct current converter 110 outputs a voltage that is sent to the pulse width modulator 140 through an inductor L and a capacitor C2. The feedback branch 120 includes a resistor R3 and a resistor R4, where the resistor R3 and the resistor R4 divide the voltage output by the output end of the direct current/direct current converter 110, and input a divided voltage to the second input end of the direct current/direct current converter 110. The pulse input branch 130 includes a resistor R1, a capacitor C1 and a resistor R2. The resistor R2 and the capacitor C1 form a low-pass filter, which converts an alternating current voltage output by the pulse width modulator 140 into a direct current voltage, and inputs the direct current voltage to the second input end of the direct current/direct current converter 110 through the resistor R1.

The direct current/direct current converter 110 determines, according to the voltage input by the first input end and the voltage input by the second input end, an output voltage Vout output by the output end of the direct current/direct current converter 110. The output voltage Vout is then fed back through the feedback branch 120 to the second input end of the direct current/direct current converter 110 for dynamically adjusting the output voltage Vout of the direct current/direct current converter 110. Likewise, the output voltage Vout is input to the pulse width modulator 140 for adjusting a width of a pulse output by the pulse width modulator 140, and an adjusted pulse is input to the second input end of the direct current/direct current converter 110, so as to dynamically adjust the output voltage Vout of the direct current/direct current converter 110.

It can be known from analysis of the dynamic voltage-adjusting circuit according to the foregoing principle that, the output voltage Vout meets formula (1) shown below:

$$Vout = Vref\left(1+\left(R3/R4\right)\right)+\left(Vref-Vpwm\right)\left(R3/\left(R1+R2\right)\right) \quad \text{formula (1)}$$

According to formula (1), if R1, R2, R3, R4 and Vref are deterministic, the output voltage Vout and the pulse voltage Vpwm meet a linear relationship.

The direct current/direct current converter 110 itself is a voltage feedback amplifier circuit, which serves to adjust an output voltage by adjusting a feedback voltage. A PWM signal is equivalent to compensation for a feedback signal. After PWM signals with different duty cycles pass through a low-pass filter, the low-pass filter outputs direct current levels with different voltages ranging from 0 to 3.3 V. As shown in FIG 1, a Central Processing Unit (CPU) dynamically adjusts a PWM duty cycle so that a feedback voltage of the direct current/direct current converter 110 can be dynamically compensated, thereby achieving an effect of dynamically adjusting the output voltage of the direct current/direct current converter 110.

In the existing design, hardware architecture designs and hardware component parameters of all dynamic voltage-adjusting circuits are the same. When a dynamic voltage-adjusting circuit is used for secondary development, different reference voltages Vref can be applied to suit development needs. However, according to formula (1), when R1, R2, R3 and R4 are set to a fixed value but the reference voltage Vref varies, the linear relationship between the output voltage Vout and the pulse voltage Vpwm varies, which means that a different reference voltage Vref results in a different range of the output voltages Vout that can be adjusted by the dynamic voltage-adjusting circuit according to the pulse voltage Vpwm.

Software on the pulse width modulator 140 is responsible for adjusting the output voltage Vout according to the pulse voltage. The software may run on the CPU, and a linear relationship determined between the output voltage Vout and the pulse voltage Vpwm according to a particular reference voltage Vref is pre-stored in the software. In this case, if the pulse width modulator 140 outputs the pulse voltage Vpwm, the direct current/direct current converter 110 outputs the Vout according to the pre-stored linear relationship. However, when the reference voltage Vref changes, a range of the output voltage Vout changes. To address this problem, the prior art has resorted to using multiple versions of software, with each version corresponding to a linear relationship specific to a particular reference voltage. However, using different versions of software brings inconvenience to software maintenance.

US 2014/103993 discloses a voltage regulator circuit, including: a parameter detecting module, configured to detect an attribute parameter of a chip; a Pulse Width Modulation (PWM) signal generating module, configured to generate a corresponding PWM digital signal according to the detected attribute parameter, and convert the PWM digital signal into an analog signal having a direct-current voltage; and a power supply module, including a DC-DC converter or a low-dropout regulator, which is configured to regulate an output voltage according to the analog signal that is fed back and a feedback signal of the voltage output end of the voltage regulator circuit.

US 2007/090819 discloses a DC-DC converter applicable to a wide input voltage range. An error amplifier compares a divided voltage, which is generated by dividing output voltage with a plurality of resistors, and a reference voltage to generate an error signal. A voltage source generates an offset signal by offsetting the error signal. A PWM comparator compares the offset signal with a triangular wave signal to generate a drive signal for controlling activation and inactivation of a first output transistor and a second transistor at a duty corresponding to the comparison result.

Buiatti G M et al: "An unified method for estimating the parameters of non-isolated DC/DC converters using continuous time model", Telecommunications Energy Conference, 2007, pp. 334-341 discloses a novel online technique used for estimating the parameters of non-ioslated Buck, Boost and Buck-Boost DC/DC converters is presented. Continuous time models of each converter are used in the estimation procedure, where the derivative calculation problem of needed signals is solved by polynomial interpolation.

## SUMMARY

The present application proposes a method and apparatus for determining resistance values of a dynamic voltage-adjusting circuit. By adjusting resistance values of multiple resistors in the dynamic voltage-adjusting circuit, voltage values output by the dynamic voltage-adjusting circuit can fall within a same range when a reference voltage takes different values.

One aspect of the present application provides a method according to claim 1 for determining resistance values of a dynamic voltage-adjusting circuit, where the dynamic voltage-adjusting circuit includes: a direct current/direct current converter, a feedback branch, a pulse input branch, and a pulse width modulator, where a first input end of the direct current/direct current converter is configured to input a reference voltage, a second input end of the direct current/direct current converter is configured to receive a signal fed back through the feedback branch and a pulse signal input by the pulse width modulator through the pulse input branch, and an output end of the direct current/direct current converter outputs a signal to the pulse width modulator, where the pulse signal is used to compensate for the feedback signal, the direct current/direct current converter compares the feedback signal compensated by the pulse signal with the reference voltage to adjust the output signal, and a linear relationship between the pulse signal and the output signal varies with the reference voltage; and the method includes:

determining a reference voltage, a maximum output voltage value, and a minimum output voltage value of the dynamic voltage-adjusting circuit, where the maximum output voltage value is a voltage output by the dynamic voltage-adjusting circuit when the pulse width modulator inputs a minimum pulse voltage through the pulse input branch, and the minimum output voltage value is a voltage output by the dynamic voltage-adjusting circuit when the pulse width modulator inputs a maximum pulse voltage through the pulse input branch; determining, according to the reference voltage and the maximum output voltage value, a first relational expression between the reference voltage, the maximum output voltage value, and multiple resistors in the feedback branch and the pulse input branch of the dynamic voltage-adjusting circuit, and determining, according to the reference voltage and the minimum output voltage value, a second relational expression between the reference voltage, the minimum output voltage value, and the multiple resistors; and determining, according to the first relational expression and the second relational expression, a group of resistance values, corresponding to the reference voltage, of the multiple resistors.

In the first aspect, the pulse input branch includes include a first resistor, a first capacitor and a second resistor, where one end of the first resistor is connected to the second input end of the direct current/direct current converter, the other end of the first resistor is connected to one end of both the first capacitor and the second resistor, the other end of the first capacitor is grounded, and the other end of the second resistor is connected to an output end of the pulse width modulator; and the determining, according to the first relational expression and the second relational expression, a group of resistance values of the multiple resistors includes: setting a resistance value of the second resistor to a fixed value; and determining, according to the resistance value of the second resistor, the first relational expression and the second relational expression, a group of resistance values, corresponding to the reference voltage, of the multiple resistors.

In the first aspect, the first resistor is formed by at least two resistors connected in series.

With reference to the first aspect, in a first possible implementation of the first aspect of the present application, the feedback branch includes a third resistor and a fourth resistor, where the third resistor and the fourth resistor divide a voltage output by the output end of the direct current/direct current converter, and input a divided voltage to the second input end of the direct current/direct current converter.

With reference to the first possible implementation of the first aspect, in a second possible implementation of the first aspect of the present application, the first relational expression is:

$$V\max = Vref\left(1+\left(R3/R4\right)\right)+\left(Vref-Vpwm\left(\min\right)\right)\left(R3/\left(R1+R2\right)\right);$$

where Vmax is the maximum output voltage value, Vref is the reference voltage, R1 is the first resistor, R2 is the second resistor, R3 is the third resistor, R4 is the fourth resistor, and Vpwm(min) is the minimum pulse voltage; and the second relational expression is:

$$V\min = Vref\left(1+\left(R3/R4\right)\right)+\left(Vref-Vpwm\left(\max\right)\right)\left(R3/\left(R1+R2\right)\right),$$

where Vmin is the minimum output voltage value, and Vpwm(max) is the maximum pulse voltage.

A second aspect of the application provides an apparatus acording to claim 4 for determining resistance values of a dynamic voltage-adjusting circuit, where the dynamic voltage-adjusting circuit includes: a direct current/direct current converter, a feedback branch, a pulse input branch, and a pulse width modulator, where a first input end of the direct current/direct current converter is configured to input a reference voltage, a second input end of the direct current/direct current converter is configured to receive a signal fed back through the feedback branch and a pulse signal input by the pulse width modulator through the pulse input branch, and an output end of the direct current/direct current converter outputs a signal to the pulse width modulator, where the pulse signal is used to compensate for the feedback signal, the direct current/direct current converter compares the feedback signal compensated by the pulse signal with the reference voltage to adjust the output signal, and a linear relationship between the pulse signal and the output signal varies with the reference voltage; the apparatus includes:

a voltage determining module, a relational expression determining module, and a resistance value searching module, where the voltage determining module is configured to determine a reference voltage, a maximum output voltage value, and a minimum output voltage value of the dynamic voltage-adjusting circuit, where the maximum output voltage value is a voltage output by the dynamic voltage-adjusting circuit when the pulse width modulator inputs a minimum pulse voltage through the pulse input branch, and the minimum output voltage value is a voltage output by the dynamic voltage-adjusting circuit when the pulse width modulator inputs a maximum pulse voltage through the pulse input branch; and the voltage determining module sends the reference voltage, the maximum output voltage value, and the minimum output voltage value to the relational expression determining module; the relational expression determining module is configured to receive the reference voltage, the maximum output voltage value, and the minimum output voltage value, determines, according to the reference voltage and the maximum output voltage value, a first relational expression between the reference voltage, the maximum output voltage value, and the multiple resistors, and determine, according to the reference voltage and the minimum output voltage value, a second relational expression between the reference voltage, the minimum output voltage value, and the multiple resistors; and the relational expression determining module sends the first relational expression and the second relational expression to the resistance value searching module; and the resistance value searching module is configured to receive the first relational expression and the second relational expression, and determine, according to the first relational expression and the second relational expression, a group of resistance values of the multiple resistors.

In the second aspect, the pulse input branch includes a first resistor, a first capacitor and a second resistor, where one end of the first resistor is connected to the second input end of the direct current/direct current converter, the other end of the first resistor is connected to one end of both the first capacitor and the second resistor, the other end of the first capacitor is grounded, and the other end of the second resistor is connected to an output end of the pulse width modulator; and the resistance value searching module is configured to set a resistance value of the second resistor to a fixed value, and determine, according to the resistance value of the second resistor, the first relational expression and the second relational expression, a group of resistance values, corresponding to the reference voltage, of the multiple resistors.

In the second aspect, the first resistor is formed by at least two resistors connected in series.

With reference to the second aspect, in a first possible implementation of the second aspect of the present application, the feedback branch includes a third resistor and a fourth resistor, where the third resistor and the fourth resistor divide a voltage output by the output end of the direct current/direct current converter, and input a divided voltage to the second input end of the direct current/direct current converter.

With reference to the first possible implementation of the second aspect, in a second possible implementation of the second aspect of the present application, the first relational expression is:

$$V\max = Vref\left(1+\left(R3/R4\right)\right)+\left(Vref-Vpwm\left(\min\right)\right)\left(R3/\left(R1+R2\right)\right);$$

where Vmax is the maximum output voltage value, Vref is the reference voltage, R1 is the first resistor, R2 is the second resistor, R3 is the third resistor, R4 is the fourth resistor, and Vpwm(min) is the minimum pulse voltage; and the second relational expression is:

$$V\min = Vref\left(1+\left(R3/R4\right)\right)+\left(Vref-Vpwm\left(\max\right)\right)\left(R3/\left(R1+R2\right)\right),$$

where Vmin is the minimum output voltage value, and Vpwm(max) is the maximum pulse voltage.

In embodiments of the present invention, a reference voltage, a maximum output voltage value, and a minimum output voltage value of a dynamic voltage-adjusting circuit are determined first; then, a first relational expression between the reference voltage, the maximum output voltage value, and multiple resistors in a feedback branch and a pulse input branch of the dynamic voltage-adjusting circuit are determined according to the reference voltage and the maximum output voltage value, and meanwhile, a second relational expression between the reference voltage, the minimum output voltage value, and the multiple resistors are determined according to the reference voltage and the minimum output voltage value; finally, a group of resistance values of the multiple resistors are determined according to the first relational expression and the second relational expression. It can be seen that, when the maximum output voltage value and the minimum output voltage value are definite, the group of resistance values of the multiple resistors vary with the reference voltage. Therefore, by adjusting the resistance values of the multiple resistors to fit with the varying reference voltage, it is ensured that the maximum output voltage value and the minimum output voltage value output by the dynamic voltage-adjusting circuit can remain unchanged when the reference voltage takes different values, that is to say, the output voltage values are within a same range. Therefore, there is no need to use multiple versions of software to adjust the output voltage of the dynamic voltage-adjusting circuit, which facilitates ease in software maintenance.

**BRIEF DESCRIPTION OF DRAWINGS**

FIG.1 is a schematic structural diagram depicting an implementation of a dynamic voltage-adjusting circuit in the prior art;

FIG.2 is a flow chart illustrating an implementation of a method for determining resistance values of a dynamic voltage-adjusting circuit according to the present application;

FIG.3 is a schematic structural diagram depicting an implementation of an apparatus for determining resistance values of a dynamic voltage-adjusting circuit according to the present application; and

FIG.4 is a schematic structural diagram depicting another implementation of an apparatus for determining resistance values of a dynamic voltage-adjusting circuit according to the present application.

**DESCRIPTION OF EMBODIMENTS**

In the following description, specific details such as a particular system structure, an interface, and a technology are set forth in an illustrative rather than a restrictive sense to provide a thorough understanding of the present application. However, a person skilled in the art should understand that the present application may also be practiced in other implementation manners without these specific details. In other instances, well-known apparatuses, circuits and methods are not described in detail so as not to unnecessarily obscure description of the present application.

In the present invention, a dynamic voltage-adjusting circuit includes: a direct current/direct current converter, a feedback branch, a pulse input branch, and a pulse width modulator, where a first input end of the direct current/direct current converter is configured to input a reference voltage, a second input end of the direct current/direct current converter is configured to receive a signal fed back through the feedback branch and a pulse signal input by the pulse width modulator through the pulse input branch, and an output end of the direct current/direct current converter outputs a signal to the pulse width modulator, where the pulse signal is used to compensate for the feedback signal; the direct current/direct current converter compares the feedback signal compensated by the pulse signal with the reference voltage to adjust the output signal; a linear relationship between the pulse signal and the output signal varies with the reference voltage; and an apparatus for determining resistance values of the dynamic voltage-adjusting circuit may determine, according to the reference voltage, resistance values of multiple resistors of the feedback branch and the pulse input branch to determine the linear relationship. FIG.2 is a flow chart illustrating an implementation of a method for determining resistance values of a dynamic voltage-adjusting circuit according to the present application. The method for determining resistance values of a dynamic voltage-adjusting circuit according to the implementation includes the following steps:

S201. Determine a reference voltage, a maximum output voltage value, and a minimum output voltage value of the dynamic voltage-adjusting circuit.

The dynamic voltage-adjusting circuit shown in FIG.1 is used as an example. Unlike in FIG. 1, in this implementation, resistance values of resistors in a feedback branch and a pulse input branch of the dynamic voltage-adjusting circuit are not yet determined. After the maximum output voltage value and the minimum output voltage value of the dynamic voltage-adjusting circuit are determined, the determined maximum output voltage values and minimum output voltage values of the dynamic voltage-adjusting circuit are applied to all hardware versions that run a same software version. The maximum output voltage value of the dynamic voltage-adjusting circuit is a voltage value produced when the pulse width modulator outputs a minimum value, and the minimum output voltage value of the dynamic voltage-adjusting circuit is a voltage value produced when the pulse width modulator outputs a maximum value. For example, a maximum output voltage value Vmax of the dynamic voltage-adjusting circuit is a voltage value produced when the pulse width modulator outputs a minimum value of 0 V, and a minimum output voltage value Vmin of the dynamic voltage-adjusting circuit is a voltage value produced when the pulse width modulator outputs a maximum value of 3.3 V.

Then, when the dynamic voltage-adjusting circuit is used for secondary development, a reference voltage of the dynamic voltage-adjusting circuit is determined according to a need. After the reference voltage, the maximum output voltage value of the dynamic voltage-adjusting circuit, and the minimum output voltage value of the dynamic voltage-adjusting circuit are all determined, they are input to an apparatus that practices this method to determine resistance values of the dynamic voltage-adjusting circuit.

S202. Determine, according to the reference voltage and the maximum output voltage value, a first relational expression between the reference voltage, the maximum output voltage value, and multiple resistors in the feedback branch and the pulse input branch of the dynamic voltage-adjusting circuit; and determine, according to the reference voltage and the minimum output voltage value, a second relational expression between the reference voltage, the minimum output voltage value, and the multiple resistors.

As mentioned above, by way of example, the maximum output voltage value Vmax of the dynamic voltage-adjusting circuit is a voltage value produced when the pulse width modulator outputs a minimum value of 0 V, and the minimum output voltage value Vmin of the dynamic voltage-adjusting circuit is a voltage value produced when the pulse width modulator outputs a maximum value of 3.3 V It is known that formula (1) is:

$$Vout = Vref\left(1+\left(R3\,/\,R4\right)\right)+\left(Vref-Vpwm\right)\left(R3\,/\,\left(R1+R2\right)\right),$$

the reference voltage Vref, the maximum output voltage value Vmax, the minimum output voltage value Vmin, a minimum pulse voltage Vpwm(min) corresponding to the maximum output voltage value Vmax, and a maximum pulse voltage Vpwm(max) corresponding to the minimum output voltage value Vmin are substituted into the formula, to obtain a first relational expression for the Vmax and a second relational expression for the Vmin:

$$V\max = Vref\left(1+\left(R3\,/\,R4\right)\right)+\left(Vref-Vpwm\left(\min\right)\right)\left(R3\,/\,\left(R1+R2\right)\right)$$
$$= Vref\left(1+\left(R3\,/\,R4\right)\right)+Vref\left(R3\,/\,\left(R1+R2\right)\right) \qquad \text{formula (2)}$$

$$V\min = Vref\left(1+\left(R3/R4\right)\right)+\left(Vref-Vpwm\left(\max\right)\right)\left(R3/\left(R1+R2\right)\right)$$
$$= Vref\left(1+\left(R3/R4\right)\right)+\left(Vref-3.3\right)\left(R3/\left(R1+R2\right)\right) \qquad \text{formula (3).}$$

In combination with formula (2) and (3), relational expressions between the reference voltage, the maximum output voltage value, and the minimum output voltage value of the dynamic voltage-adjusting circuit of the version, and the resistors in the feedback branch and pulse input branch of the dynamic voltage-adjusting circuit can be obtained, such as formula (4) and formula (5).

$$1+\left(R3/R4\right)=\left(V\max/Vref\right)-\left(V\max-V\min\right)/3.3 \qquad \text{formula (4);}$$

$$R3/\left(R1+R2\right)=\left(V\max-V\min\right)/3.3 \qquad \text{formula (5).}$$

It should be understood that, in the statement that the maximum output voltage value Vmax of the dynamic voltage-adjusting circuit is a voltage value produced when the pulse width modulator outputs a minimum value of 0 V, and the minimum output voltage value Vmin of the dynamic voltage-adjusting circuit is a voltage value produced when the pulse width modulator outputs a maximum value of 3.3 V, 0 V and 3.3 V are merely example values and other values may be applied in other implementations, which are not specifically limited herein.

S203. Determine, according to the first relational expression and the second relational expression, a group of resistance values, corresponding to the reference voltage, of the multiple resistors.

A resistor R2 and a capacitor C1 form a low-pass filter, which converts an alternating current voltage output by the pulse width modulator into a direct current voltage. Time needed for the resistor R2 and the capacitor C1 to convert an output alternating current voltage into a direct current voltage is referred to as voltage regulation time. To ensure that the voltage regulation time can be same for dynamic voltage-adjusting circuits of different versions, a resistance value of the resistor R2 may be set to a fixed value.

After the resistance value of the resistor R2 is set to a fixed value, attempts will be made to search for a group of resistors R1, R2, R3 and R4 that meet formula (4) and formula (5). Generally, the resistor R1 that is found to meet the formulas has to provide extremely high resistance, and it would be a significant technical challenge to manufacture an individual resistor with such high resistance. For this reason, the resistor R1 may be formed by at least two resistors R11 and R12 connected in series.

After the foregoing method is applied, with Vmax=1.32V and Vmin=0.9V, resistance values, corresponding to reference voltages, of the resistors can be obtained, as shown in Table 1.

**Table 1**

| Resistance values of resistors in the case of (Vmax=1.32 and Vmin=0.9) | | | | | |
|---|---|---|---|---|---|
| Vref (volt) | R11 (kilo-ohm) | R12 (kilo-ohm) | R2 (kilo-ohm) | R3 (kilo-ohm) | R4 (kilo-ohm) |
| 0.6 | 14.7 | 100 | 1 | 14.7 | 13.7 |
| 0.8 | 4.99 | 200 | 1 | 26.1 | 49.9 |
| 0.807 | 5.49 | 150 | 1 | 20 | 39.2 |
| 0.765 | 12 | 200 | 1 | 27 | 45.3 |
| 0.92 | 11 | 82 | 1 | 12 | 39 |
| 0.923 | 33 | 113 | 1 | 18.7 | 61.9 |
| 0.925 | 34.8 | 121 | 1 | 20 | 66.5 |

In this embodiment, a reference voltage, a maximum output voltage value, and a minimum output voltage value of a dynamic voltage-adjusting circuit are determined first; then, a first relational expression between a reference voltage, the maximum output voltage value, and multiple resistors in a feedback branch and a pulse input branch of the dynamic voltage-adjusting circuit are determined according to the reference voltage and the maximum output voltage value, and meanwhile, a second relational expression between the reference voltage, the minimum output voltage value, and the multiple resistors is determined according to the reference voltage and the minimum output voltage value; finally, a group of resistance values of the multiple resistors are determined according to the first relational expression and the second relational expression. It can be seen that, when the maximum output voltage value and the minimum output voltage value are definite, the group of resistance values of the multiple resistors vary with the reference voltage. Therefore, by adjusting the resistance values of the multiple resistors to fit with the varying reference voltage, it is ensured that the maximum output voltage value and the minimum output voltage value output by the dynamic voltage-adjusting circuit can remain unchanged when the reference voltage takes different values, that is to say, the output voltage values are within a same range. Therefore, there is no need to use multiple versions of software to adjust the output voltage of the dynamic voltage-adjusting circuit, which facilitates ease in software maintenance.

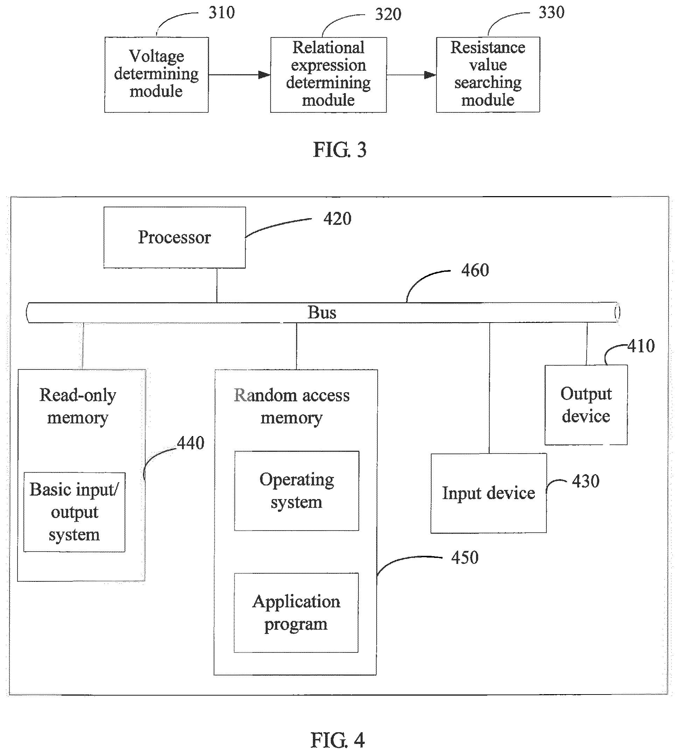

FIG.3 is a schematic structural diagram depicting an implementation of an apparatus for determining resistance values of a dynamic voltage-adjusting circuit. According to the present implementation, the apparatus for determining resistance values of a dynamic voltage-adjusting circuit includes: a voltage determining module 310, a relational expression determining 320, and a resistance value searching module 330.

The voltage determining module 310 is configured to determine a reference voltage, a maximum output voltage value, and a minimum output voltage value of the dynamic voltage-adjusting circuit, where the maximum output voltage value is a voltage output by the dynamic voltage-adjusting circuit when a pulse width modulator inputs a minimum pulse voltage through a pulse input branch, and the minimum output voltage value is a voltage output by the dynamic voltage-adjusting circuit when the pulse width modulator inputs a maximum pulse voltage through the pulse input branch. The voltage determining module 310 sends the reference voltage, the maximum output voltage value, and the minimum output voltage value to the relational expression determining module 320.

The relational expression determining module 320 is configured to receive the reference voltage, the maximum output voltage value, and the minimum output voltage value; determine, according to the reference voltage and the maximum output voltage value, a first relational expression between the reference voltage, the maximum output voltage value, and multiple resistors in a feedback branch and the pulse input branch of the dynamic voltage-adjusting circuit; and determine, according to the reference voltage and the minimum output voltage value, a second relational expression between the reference voltage, the minimum output voltage value, and the multiple resistors. The relational expression determining module 320 sends the first relational expression and the second relational expression to the resistance value searching module 330.

The resistance value searching module 330 is configured to receive the first relational expression and the second relational expression, and determine, according to the first relational expression and the second relational expression, a group of resistance values of the multiple resistors.

Optionally, the pulse input branch includes a first resistor, a first capacitor, and a second resistor, where one end of the first resistor is connected to a second input end of a direct current/direct current converter, the other end of the first resistor is connected to one end of both the first capacitor and the second resistor, the other end of the first capacitor is grounded, and the other end of the second resistor is connected to the pulse width modulator; and the resistance value searching module 330 is configured to set a resistance value of the second resistor to a fixed value, and determine, according to the resistance value of the second resistor, the first relational expression and the second relational expression, a group of resistance values of the multiple resistors.

Optionally, the first resistor is formed by at least two resistors connected in series.

Optionally, the feedback branch includes a third resistor and a fourth resistor, where the third resistor and the fourth resistor divide a voltage output by an output end of the direct current/direct current converter, and input a divided voltage to the second input end of the direct current/direct current converter.

Optionally, the first relational expression is:

$$V\max = Vref\left(1+\left(R3/R4\right)\right)+\left(Vref-Vpwm\left(\min\right)\right)\left(R3/\left(R1+R2\right)\right),$$

where Vmax is the maximum output voltage value, Vref is the reference voltage, R1 is the first resistor, R2 is the second resistor, R3 is the third resistor, R4 is the fourth resistor, and Vpwm(min) is the minimum pulse voltage; the second relational expression is:

$$V\min = Vref\left(1+\left(R3/R4\right)\right)+\left(Vref-Vpwm\left(\max\right)\right)\left(R3/\left(R1+R2\right)\right),$$

where Vmin is the minimum output voltage value, Vref is the reference voltage, R1 is the first resistor, R2 is the second resistor, R3 is the third resistor, R4 is the fourth resistor, and Vpwm(max) is the maximum pulse voltage.

It should be understood that the apparatus shown in FIG. 3 can execute steps of the embodiment corresponding to FIG. 2.

Referring to FIG 4, FIG. 4 is a schematic structural diagram depicting an implementation of an apparatus for determining resistance values of a dynamic voltage-adjusting circuit. According to this implementation, the apparatus for determining resistance values of a dynamic voltage-adjusting circuit includes: an input device 410, a processor 420, an output device 430, a random access memory 440, a read-only memory 450, and a bus 460.

The input device 410 is configured to input data.

The processor 420 controls an operation of the apparatus for determining resistance values of a dynamic voltage-adjusting circuit, and the processor 420 may also be called a CPU. The processor 420 may be an integrated circuit chip with a signal processing capability. The processor 420 may also be a general purpose processor, a digital signal processor (DSP), an application-specific integrated circuit (ASIC), a field-programmable gate array (FPGA) or another programmable logic device, a discrete gate or a transistor logic device, or a discrete hardware component. A general purpose processor may be a microprocessor, or the processor may be any conventional processor, or the like.

The output device 430 is configured to output data.

The memory may include the read-only memory 440 and the random access memory 450, and provide instructions and data for the processor 420. A part of the memory may also include a non-volatile random access memory (NVRAM).

Components of the apparatus for determining resistance values of a dynamic voltage-adjusting circuit are coupled to each other through the bus 460, where the bus 460 may include a data bus, and may also include a power bus, a control bus, a status signal bus, and so on. For clarity purposes, various buses are all marked as the bus 460 in the figure.

The memory stores the following elements, executable modules or data structures, or their subsets, or their extension sets:

> operation instruction: including a variety of operation instructions and used to implement various operations; and
> operating system: including a variety of system programs and used to implement various basic services and process hardware-based tasks.

In this embodiment of the present invention, the processor 420 invokes an operation instruction stored in the memory (the operation instruction may be stored in an operating system), to perform the following operations:

> the processor 420 determines a reference voltage, a maximum output voltage value, and a minimum output voltage value of the dynamic voltage-adjusting circuit, where the maximum output voltage value is a voltage output by the dynamic voltage-adjusting circuit when a pulse width modulator inputs a minimum pulse voltage through a pulse input branch, and the minimum output voltage value is a voltage output by the dynamic voltage-adjusting circuit when the pulse width modulator inputs a maximum pulse voltage through the pulse input branch;
> the processor 420 determines, according to the reference voltage and the maximum output voltage value, a first relational expression between the reference voltage, the maximum output voltage value, and multiple resistors in a feedback branch and the pulse input branch of the dynamic voltage-adjusting circuit, and determines, according to the reference voltage and the minimum output voltage value, a second relational expression between the reference voltage, the minimum output voltage value, and the multiple resistors; and
> the processor 420 determines, according to the first relational expression and the second relational expression, a group of resistance values of the multiple resistors.

Optionally, the processor 420 sets a resistance value of a second resistor to a fixed value, and determines a group of resistance values of the multiple resistors according to the resistance value of the second resistor, the first relational expression, and the second relational expression.

Optionally, a first resistor is formed by at least two resistors connected in series.

Optionally, the feedback branch includes a third resistor and a fourth resistor, where the third resistor and the fourth resistor divide a voltage output by an output end of a direct current/direct current converter, and input a divided voltage to a second input end of the direct current/direct current converter.

Optionally, the first relational expression is:

$$V\max = Vref\left(1+\left(R3/R4\right)\right)+\left(Vref-Vpwm\left(\min\right)\right)\left(R3/\left(R1+R2\right)\right),$$

where Vmax is the maximum output voltage value, Vref is the reference voltage, R1 is the first resistor, R2 is the second resistor, R3 is the third resistor, R4 is the fourth resistor, and Vpwm(min) is the minimum pulse voltage; and the second relational expression is:

$$V\min = Vref\left(1+\left(R3/R4\right)\right)+\left(Vref-Vpwm\left(\max\right)\right)\left(R3/\left(R1+R2\right)\right),$$

where Vmin is the minimum output voltage value, Vref is the reference voltage, R1 is the first resistor, R2 is the second resistor, R3 is the third resistor, R4 is the fourth resistor, and Vpwm(max) is the maximum pulse voltage.

In this embodiment of the present invention, the apparatus for determining resistance values of a dynamic voltage-adjusting circuit determines a reference voltage, a maximum output voltage value, and a minimum output voltage value of the dynamic voltage-adjusting circuit; then determines, according to the reference voltage and the maximum output voltage value, a first relational expression between the reference voltage, the maximum output voltage value, and multiple resistors in a feedback branch and a pulse input branch of the dynamic voltage-adjusting circuit, and determines, according to the reference voltage and the minimum output voltage value, a second relational expression between the reference voltage, the minimum output voltage value, and the multiple resistors; and determines, according to the first relational expression and the second relational expression, a group of resistance values of the multiple resistors. It can be seen that, when the maximum output voltage value and the minimum output voltage value are definite, the group of resistance values of the multiple resistors vary with the reference voltage. Therefore, by adjusting the resistance values of the multiple resistors to fit with the varying reference voltage, it is ensured that the maximum output voltage value and the minimum output voltage value output by the dynamic voltage-adjusting circuit can remain unchanged when the reference voltage takes different values, that is to say, the output voltage values are within a same range. Therefore, there is no need to use software of multiple versions to adjust the output voltage of the dynamic voltage-adjusting circuit, and it is convenient to maintain software.

In this embodiment, a structure of a dynamic voltage-adjusting circuit involved in the method and apparatus for determining resistance values of a dynamic voltage-adjusting circuit may be as illustrated in FIG. 1 and Background, and details are not further described here.

In the several embodiments provided in the present application, it should be understood that the disclosed system, apparatus, and method may be implemented in others. For example, the described apparatus embodiment is merely exemplary. For example, the module or unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. A part or all of the units may be selected according to actual needs to achieve the objectives of the solutions of the embodiments.

In addition, functional units in the embodiments of the present application may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a computer-readable storage medium. Based on such an understanding, the technical solutions of the present application essentially, or the part contributing to the prior art, or all or a part of the technical solutions may be implemented in the form of a software product. The software product is stored in a storage medium and includes several instructions for instructing a computer device (which may be a personal computer, a server, or a network device) or a processor to perform all or a part of the steps of the methods described in the embodiments of the present application. The foregoing storage medium includes: any medium that can store program code, such as a USB flash drive, a removable hard disk, a read-only memory (ROM), a random access memory (RAM), a magnetic disk, or an optical disc.

## Claims

1. A method for determining resistance values of a dynamic voltage-adjusting circuit, wherein the dynamic voltage-adjusting circuit comprises: a direct current/direct current converter (110), a feedback branch (120), a pulse input branch (130), and a pulse width modulator (140), wherein a first input end of the direct current/direct current converter is configured to input a reference voltage, a second input end of the direct current/direct current converter is configured to receive a signal fed back through the feedback branch and a pulse signal input by the pulse width modulator through the pulse input branch, and an output end of the direct current/direct current converter outputs a signal to the pulse width modulator, wherein the pulse signal is used to compensate for the feedback signal, the direct current/direct current converter compares the feedback signal compensated by the pulse signal with the reference voltage to adjust the output signal, and a linear relationship between the pulse signal and the output signal varies with the reference voltage **characterized in that**, the method comprises:

determining (S201)a reference voltage (Vref), a maximum output voltage value, and a minimum output voltage value of the dynamic voltage-adjusting circuit, wherein the maximum output voltage value is a voltage output by the dynamic voltage-adjusting circuit when the pulse width modulator inputs a minimum pulse voltage through the pulse input branch, and the minimum output voltage value is a voltage output by the dynamic voltage-adjusting circuit when the pulse width modulator inputs a maximum pulse voltage through the pulse input branch; determining (S202), according to the reference voltage and the maximum output voltage value, a first relational expression between the reference voltage, the maximum output voltage value, and multiple resistors in the feedback branch and the pulse input branch of the dynamic voltage-adjusting circuit, and determining, according to the reference voltage and the minimum output voltage value, a second relational expression between the reference voltage, the minimum output voltage value, and the multiple resistors; and determining (S203), according to the first relational expression and the second relational expression, a group of resistance values, corresponding to the reference voltage, of the multiple resistors; wherein the pulse input branch comprises a first resistor (R1), a first capacitor (C1) and a second resistor (R2), wherein one end of the first resistor is connected to the second input end of the direct current/direct current converter, the other end of the first resistor is connected to one end of both the first capacitor and the second resistor, the other end of the first capacitor is grounded, and the other end of the second resistor is connected to an output end of the pulse width modulator; and the determining (S203), according to the first relational expression and the second relational expression, a group of resistance values of the multiple resistors comprises:

setting a resistance value of the second resistor to a fixed value; and determining, according to the resistance value of the second resistor, the first relational expression and the second relational expression, a group of resistance values, corresponding to the reference voltage, of the multiple resistors; wherein the first resistor (R1), which has to provide extremely high resistance, is formed by at least two resistors (R11, R12) connected in series.

2. The method according to claim 1, wherein the feedback branch (120) comprises a third resistor (R3) and a fourth resistor (R4), wherein the third resistor and the fourth resistor divide a voltage output by the output end of the direct current/direct current converter (110), and input a divided voltage to the second input end of the direct current/direct current converter.

3. The method according to claim 2, wherein:

the first relational expression is:

$$V\max = Vref\left(1 + \left(R3\,/\,R4\right)\right) + \left(Vref - Vpwm\left(\min\right)\right)\left(R3\,/\,\left(R1 + R2\right)\right),$$

wherein Vmax is the maximum output voltage value, Vref is the reference voltage, R1 is the first resistor, R2 is the second resistor, R3 is the third resistor, R4 is the fourth resistor, and Vpwm(min) is the minimum pulse voltage; and the second relational expression is:

$$V\min = Vref\left(1 + \left(R3\,/\,R4\right)\right) + \left(Vref - Vpwm\left(\max\right)\right)\left(R3\,/\,\left(R1 + R2\right)\right),$$

wherein Vmin is the minimum output voltage value, and Vpwm(max) is the maximum pulse voltage.

4. An apparatus for determining resistance values of a dynamic voltage-adjusting circuit, wherein the dynamic voltage-adjusting circuit comprises: a direct current/direct current converter (110), a feedback branch (120), a pulse input branch (130), and a pulse width modulator (140), wherein a first input end of the direct current/direct current converter is configured to input a reference voltage (Vref), a second input end of the direct current/direct current converter is configured to receive a signal fed back through the feedback branch and a pulse signal input by the pulse width modulator through the pulse input branch, and an output end of the direct current/direct current converter outputs a signal to the pulse width modulator, wherein the pulse signal is used to compensate for the feedback signal, the direct current/direct current converter compares the feedback signal compensated by the pulse signal with the reference voltage to adjust the output signal, and a linear relationship between the pulse signal and the output signal varies with the reference voltage; and

the apparatus is configured to determine, according to the reference voltage, resistance values of multiple resistors in the feedback branch and the pulse input branch to determine the linear relationship;

**characterized in that** the apparatus comprises: a voltage determining module (310), a relational expression determining module (320), and a resistance value searching module (330), wherein

the voltage determining module (310) is configured to determine a reference voltage, a maximum output voltage value, and a minimum output voltage value of the dynamic voltage-adjusting circuit, wherein the maximum output voltage value is a voltage output by the dynamic voltage-adjusting circuit when the pulse width modulator inputs a minimum pulse voltage through the pulse input branch, and the minimum output voltage value is a voltage output by the dynamic voltage-adjusting circuit when the pulse width modulator inputs a maximum pulse voltage through the pulse input branch; and the voltage determining module sends the reference voltage, the maximum output voltage value, and the minimum output voltage value to the relational expression determining module;

the relational expression determining module (320) is configured to receive the reference voltage, the maximum output voltage value, and the minimum output voltage value, determine, according to the reference voltage and the maximum output voltage value, a first relational expression between the reference voltage, the maximum output voltage value, and the multiple resistors, and determine, according to the reference voltage and the minimum output voltage value, a second relational expression between the reference voltage, the minimum output voltage value, and the multiple resistors; and send the first relational expression and the second relational expression to the resistance value searching module; and

the resistance value searching module (330) is configured to receive the first relational expression and the second relational expression, and determine, according to the first relational expression and the second relational expression, a group of resistance values of the multiple resistors;

wherein the pulse input branch comprises a first resistor (R1), a first capacitor (C1) and a second resistor (R2), wherein one end of the first resistor is connected to the second input end of the direct current/direct current converter, the other end of the first resistor is connected to one end of both the first capacitor and the second resistor, the other end of the first capacitor is grounded, and the other end of the second resistor is connected to an output end of the pulse width modulator; and the resistance value searching module is configured to set a resistance value of the second resistor to a fixed value, and determine, according to the resistance value of the second resistor, the first relational expression and the second relational expression, a group of resistance values, corresponding to the reference voltage, of the multiple resistors;

wherein the first resistor (R1), which has to provide extremely high resistance, is formed by at least two resistors (R11, R12) connected in series.

5. The apparatus according to claim 4, wherein the feedback branch (120) comprises a third resistor (R3) and a fourth resistor (R4), wherein the third resistor and the fourth resistor divide a voltage output by the output end of the direct current/direct current converter (110), and input a divided voltage to the second input end of the direct current/direct current converter.

6. The apparatus according to claim 5, wherein:

the first relational expression is:

$$V\max = Vref\left(1+\left(R3/R4\right)\right)+\left(Vref-Vpwm\left(\min\right)\right)\left(R3/\left(R1+R2\right)\right)$$

wherein Vmax is the maximum output voltage value, Vref is the reference voltage, R1 is the first resistor, R2 is the second resistor, R3 is the third resistor, R4 is the fourth resistor, and Vpwm(min) is the minimum pulse voltage; and

the second relational expression is:

$$V\min = Vref\left(1+\left(R3/R4\right)\right)+\left(Vref-Vpwm\left(\max\right)\right)\left(R3/\left(R1+R2\right)\right),$$

wherein Vmin is the minimum output voltage value, and Vpwm(max) is the maximum pulse voltage.

**Patentansprüche**

1. Verfahren zum Bestimmen der Widerstandswerte einer dynamischen spannungsanpassenden Schaltung, wobei die dynamische spannungsanpassende Schaltung Folgendes umfasst: einen Gleichstrom-/Gleichstromwandler (110), einen Rückführungszweig (120), einen Impulseingangszweig (130) und einen Impulsbreitenmodulator (140), wobei ein erstes Eingangsende des Gleichstrom-/Gleichstromwandlers dazu ausgestaltet ist, eine Referenzspannung einzugeben, ein zweites Eingangsende des Gleichstrom-/Gleichstromwandlers dazu ausgestaltet ist, ein Signal, das durch den Rückführungszweig hindurch zurückgeführt wird, und ein Impulssignal, das durch den Impulsbreitenmodulator durch den Impulseingangszweig hindurch eingegeben wird, zu empfangen, und ein Ausgangsende des Gleichstrom-/Gleichstromwandlers ein Signal an den Impulsbreitenmodulator ausgibt, wobei das Impulssignal dazu verwendet wird, das Rückführungssignal zu kompensieren, der Gleichstrom-/Gleichstromwandler das Rückführungssignal, das durch das Impulssignal kompensiert wird, mit der Referenzspannung vergleicht, um das Ausgangssignal anzupassen, und eine lineare Beziehung zwischen dem Impulssignal und dem Ausgangssignal mit der Referenzspannung variiert, **dadurch gekennzeichnet, dass** das Verfahren Folgendes umfasst:

   Bestimmen (S201) einer Referenzspannung (Vref), eines maximalen Ausgangsspannungswertes und eines minimalen Ausgangsspannungswertes der dynamischen spannungsanpassenden Schaltung, wobei es sich bei dem maximalen Ausgangsspannungswert um eine Spannung handelt, die durch die dynamische spannungsanpassende Schaltung ausgegeben wird, wenn der Impulsbreitenmodulator eine minimale Impulsspannung durch den Impulseingangszweig hindurch eingibt, und es sich bei dem minimalen Ausgangsspannungswert um eine Spannung handelt, die durch die dynamische spannungsanpassende Schaltung ausgegeben wird, wenn der Impulsbreitenmodulator eine maximale Impulsspannung durch den Impulseingangszweig hindurch eingibt;
   Bestimmen (S202), gemäß der Referenzspannung und dem maximalen Ausgangsspannungswert, eines ersten Verhältnisausdrucks zwischen der Referenzspannung, dem maximalen Ausgangsspannungswert und mehreren Widerständen in dem Rückführungszweig und dem Impulseingangszweig der dynamischen spannungsanpassenden Schaltung, und Bestimmen, gemäß der Referenzspannung und dem minimalen Ausgangsspannungswert, eines zweiten Verhältnisausdrucks zwischen der Referenzspannung, dem minimalen Ausgangsspannungswert und den mehreren Widerständen; und
   Bestimmen (S203), gemäß dem ersten Verhältnisausdruck und dem zweiten Verhältnisausdruck, einer Gruppe von Widerstandswerten, die der Referenzspannung entsprechen, der mehreren Widerstände;
   wobei der Impulseingangszweig einen ersten Widerstand (R1), einen ersten Kondensator (C1) und eine zweiten Widerstand (R2) umfasst,
   wobei ein Ende des ersten Widerstands mit dem zweiten Eingangsende des Gleichstrom-/Gleichstromwandlers verbunden ist, das andere Ende des ersten Widerstands mit einem Ende von sowohl dem ersten Kondensator als auch dem zweiten Widerstand verbunden ist, das andere Ende des ersten Kondensators geerdet ist, und das andere Ende des zweiten Widerstands mit einem Ausgangsende des Impulsbreitenmodulators verbunden ist, und
   das Bestimmen (S203), gemäß dem ersten Verhältnisausdruck und dem zweiten Verhältnisausdruck, einer Gruppe von Widerstandswerten der mehreren Widerstände, Folgendes umfasst:

      Einstellen eines Widerstandswertes des zweiten Widerstands auf einen festen Wert; und
      Bestimmen, gemäß dem Widerstandswert des zweiten Widerstands, dem ersten Verhältnisausdruck und dem zweiten Verhältnisausdruck, einer Gruppe von Widerstandswerten, die der Referenzspannung entsprechen, der mehreren Widerstände;
      wobei der erste Widerstand (R1), welcher einen äußerst hohen Widerstand zur Verfügung stellen muss, durch mindestens zwei Widerstände (R11, R12) gebildet wird, die in Reihe geschaltet sind.

2. Verfahren nach Anspruch 1, wobei der Rückführungszweig (120) einen dritten Widerstand (R3) und einen vierten Widerstand (R4) umfasst, wobei der dritte Widerstand und der vierte Widerstand eine Spannung teilen, die durch das Ausgangsende des Gleichstrom-/Gleichstromwandlers (110) ausgegeben wird, und eine geteilte Spannung in das zweite Eingangsende des Gleichstrom-/Gleichstromwandlers eingeben.

3. Verfahren nach Anspruch 2, wobei:

der erste Verhältnisausdruck lautet:

$$V\max = Vref\,(\,1 + (R3\,/\,R4)) + (Vref\,\text{-}\,Vpwm\,(\min))(R3\,/\,(R1 + R2))$$

wobei Vmax der maximale Ausgangsspannungswert ist, Vref die Referenzspannung ist, R1 der erste Widerstand ist, R2 der zweite Widerstand ist, R3 der dritte Widerstand ist, R4 der vierte Widerstand ist, und Vpwm(min) die minimale Impulsspannung ist; und
der zweite Verhältnisausdruck lautet:

$$V\min = Vref\,(1 + (R3\,/\,R4)) + (Vref\,\text{-}\,Vpwm\,(\max))(R3\,/\,(R1 + R2))$$

wobei Vmin der minimale Ausgangsspannungswert und Vpwm(max) die maximale Impulsspannung ist.

4. Einrichtung zum Bestimmen der Widerstandswerte einer dynamischen spannungsanpassenden Schaltung, wobei die dynamische spannungsanpassende Schaltung Folgendes umfasst: einen Gleichstrom-/Gleichstromwandler (110), einen Rückführungszweig (120), einen Impulseingangszweig (130) und einen Impulsbreitenmodulator (140),
wobei ein erstes Eingangsende des Gleichstrom-/Gleichstromwandlers dazu ausgestaltet ist, eine Referenzspannung (Vref) einzugeben, ein zweites Eingangsende des Gleichstrom-/Gleichstromwandlers dazu ausgestaltet ist, ein Signal, das durch den Rückführungszweig hindurch zurückgeführt wird, und ein Impulssignal, das durch den Impulsbreitenmodulator durch den Impulseingangszweig hindurch eingegeben wird, zu empfangen, und ein Ausgangsende des Gleichstrom-/Gleichstromwandlers ein Signal an den Impulsbreitenmodulator ausgibt, wobei das Impulssignal dazu verwendet wird, das Rückführungssignal zu kompensieren, der Gleichstrom-/Gleichstromwandler das Rückführungssignal, das durch das Impulssignal kompensiert wird, mit der Referenzspannung vergleicht, um das Ausgangssignal anzupassen, und eine lineare Beziehung zwischen dem Impulssignal und dem Ausgangssignal mit der Referenzspannung variiert; und
die Einrichtung dazu ausgestaltet ist, gemäß der Referenzspannung, die Widerstandswerte von mehreren Widerständen in dem Rückführungszweig und dem Impulseingangszweig zu bestimmen, um die lineare Beziehung zu bestimmen; **dadurch gekennzeichnet, dass** die Einrichtung Folgendes umfasst: ein Spannungsbestimmungsmodul (310), ein Verhältnisausdruckbestimmungsmodul (320) und ein Widerstandswertsuchmodul (330), wobei
das Spannungsbestimmungsmodul (310) dazu ausgestaltet ist, eine Referenzspannung, einen maximalen Ausgangsspannungswert und einen minimalen Ausgangsspannungswert der dynamischen spannungsanpassenden Schaltung zu bestimmen, wobei es sich bei dem maximalen Ausgangsspannungswert um eine Spannung handelt, die durch die dynamische spannungsanpassende Schaltung ausgegeben wird, wenn der Impulsbreitenmodulator eine minimale Impulsspannung durch den Impulseingangszweig hindurch eingibt, und es sich bei dem minimalen Ausgangsspannungswert um eine Spannung handelt, die durch die dynamische spannungsanpassende Schaltung ausgegeben wird, wenn der Impulsbreitenmodulator eine maximale Impulsspannung durch den Impulseingangszweig hindurch eingibt; und das Spannungsbestimmungsmodul die Referenzspannung, den maximalen Ausgangsspannungswert und den minimalen Ausgangsspannungswert an das Verhältnisausdruckbestimmungsmodul sendet;
das Verhältnisausdruckbestimmungsmodul (320) dazu ausgestaltet ist, die Referenzspannung, den maximalen Ausgangsspannungswert und den minimalen Ausgangsspannungswert zu empfangen, gemäß der Referenzspannung und dem maximalen Ausgangsspannungswert, einen ersten Verhältnisausdruck zwischen der Referenzspannung, dem maximalen Ausgangsspannungswert und den mehreren Widerständen zu bestimmen, und gemäß der Referenzspannung und dem minimalen Ausgangsspannungswert, einen zweiten Verhältnisausdruck zwischen der Referenzspannung, dem minimalen Ausgangsspannungswert und den mehreren Widerständen zu bestimmen; und den ersten Verhältnisausdruck und den zweiten Verhältnisausdruck an das Widerstandswertsuchmodul zu senden; und
das Widerstandwertsuchmodul (330) dazu ausgestaltet ist, den ersten Verhältnisausdruck und den zweiten Verhältnisausdruck zu empfangen, und gemäß dem ersten Verhältnisausdruck und dem zweiten Verhältnisausdruck eine Gruppe von Widerstandswerten der mehreren Widerstände zu bestimmen;

wobei der Impulseingangszweig einen ersten Widerstand (R1), einen ersten Kondensator (C1) und eine zweiten Widerstand (R2) umfasst,

wobei ein Ende des ersten Widerstands mit dem zweiten Eingangsende des Gleichstrom-/Gleichstromwandlers verbunden ist, das andere Ende des ersten Widerstands mit einem Ende von sowohl dem ersten Kondensator als auch dem zweiten Widerstand verbunden ist, das andere Ende des ersten Kondensators geerdet ist, und das andere Ende des zweiten Widerstands mit einem Ausgangsende des Impulsbreitenmodulators verbunden ist; und das Widerstandswertsuchmodul dazu ausgestaltet ist, einen Widerstandswert des zweiten Widerstands auf einen festen Wert einzustellen, und gemäß dem Widerstandswert des zweiten Widerstands, dem ersten Verhältnisausdruck und dem zweiten Verhältnisausdruck, eine Gruppe von Widerstandswerten, die der Referenzspannung entsprechen, der mehreren Widerstände zu bestimmen;

wobei der erste Widerstand (R1), welcher einen äußerst hohen Widerstand zur Verfügung stellen muss, durch mindestens zwei Widerstände (R11, R12) gebildet wird, die in Reihe geschaltet sind.

5. Einrichtung nach Anspruch 4, wobei der Rückführungszweig (120) einen dritten Widerstand (R3) und einen vierten Widerstand (R4) umfasst,

wobei der dritte Widerstand und der vierte Widerstand eine Spannung teilen, die durch das Ausgangsende des Gleichstrom-/Gleichstromwandlers (110) ausgegeben wird, und eine geteilte Spannung in das zweite Eingangsende des Gleichstrom-/Gleichstromwandlers eingeben.

6. Einrichtung nach Anspruch 5, wobei:

der erste Verhältnisausdruck lautet:

$$V\max = Vref\,(\,1 + (R3\,/\,R4)) + (Vref\, \text{-}\, Vpwm\,(\min))(R3\,/\,(R1 + R2))$$

wobei Vmax der maximale Ausgangsspannungswert ist, Vref die Referenzspannung ist, R1 der erste Widerstand ist, R2 der zweite Widerstand ist, R3 der dritte Widerstand ist, R4 der vierte Widerstand ist, und Vpwm(min) die minimale Impulsspannung ist; und

der zweite Verhältnisausdruck lautet:

$$V\min = Vref\,(1\, + (R3\,/\,R4)) + (Vref\, \text{-}\, Vpwm\,(\max))(R3\,/\,(R1 + R2))$$

wobei Vmin der minimale Ausgangsspannungswert und Vpwm(max) die maximale Impulsspannung ist.

## Revendications

1. Procédé de détermination de valeurs de résistance d'un circuit de réglage de tension dynamique, dans lequel le circuit de réglage de tension dynamique comprend : un convertisseur continu/continu (110), une branche de rebouclage (120), une branche d'entrée d'impulsion (130), et un modulateur d'impulsions en durée (140), dans lequel une première extrémité d'entrée du convertisseur continu/continu est configurée pour fournir en entrée une tension de référence, une seconde extrémité d'entrée du convertisseur continu/continu est configurée pour recevoir un signal rebouclé à travers la branche de rebouclage et un signal d'impulsion fourni en entrée par le modulateur d'impulsions en durée à travers la branche d'entrée d'impulsion, et une extrémité de sortie du convertisseur continu/continu fournit en sortie un signal au modulateur d'impulsions en durée, dans lequel le signal d'impulsion est utilisé pour compenser le signal de rebouclage, le convertisseur continu/continu compare le signal de rebouclage compensé par le signal d'impulsion avec la tension de référence pour régler le signal de sortie, et une relation linéaire entre le signal d'impulsion et le signal de sortie varie avec la tension de référence, **caractérisé en ce que** le procédé comprend :

la détermination (S201) d'une tension de référence (Vref), d'une valeur de tension de sortie maximale, et d'une valeur de tension de sortie minimale du circuit de réglage de tension dynamique, dans lequel la valeur de tension de sortie maximale est une tension fournie en sortie par le circuit de réglage de tension dynamique lorsque le modulateur d'impulsions en durée fournit en entrée une tension d'impulsion minimale à travers la branche d'entrée d'impulsion, et la valeur de tension de sortie minimale est une tension fournie en sortie par le circuit de réglage de tension dynamique lorsque le modulateur d'impulsions en durée fournit en entrée une tension d'impulsion maximale à travers la branche d'entrée d'impulsion ;

la détermination (S202), selon la tension de référence et la valeur de tension de sortie maximale, d'une première expression relationnelle entre la tension de référence, la valeur de tension de sortie maximale, et des résistors multiples dans la branche de rebouclage et la branche d'entrée d'impulsion du circuit de réglage de tension dynamique, et la détermination, selon la tension de référence et la valeur de tension de sortie minimale, d'une seconde expression relationnelle entre la tension de référence, la valeur de tension de sortie minimale, et les résistors multiples ; et

la détermination (S203), selon la première expression relationnelle et la seconde expression relationnelle, d'un groupe de valeurs de résistance, correspondant à la tension de référence, des résistors multiples ;

dans lequel la branche d'entrée d'impulsion comprend un premier résistor (R1), un premier condensateur (C1) et un deuxième résistor (R2), dans lequel une extrémité du premier résistor est connectée à la seconde extrémité d'entrée du convertisseur continu/continu, l'autre extrémité du premier résistor est connectée à une extrémité à la fois du premier condensateur et du deuxième résistor, l'autre extrémité du premier condensateur est mise à la masse, et l'autre extrémité du deuxième résistor est connectée à une extrémité de sortie du modulateur d'impulsions en durée ; et

la détermination (S203), selon la première expression relationnelle et la seconde expression relationnelle, d'un groupe de valeurs de résistance des résistors multiples comprend :

la fixation d'une valeur de résistance du deuxième résistor à une valeur fixe ; et

la détermination, selon la valeur de résistance du deuxième résistor, la première expression relationnelle et la seconde expression relationnelle, d'un groupe de valeurs de résistance, correspondant à la tension de référence, des résistors multiples ;

dans lequel le premier résistor (R1), qui doit fournir une résistance extrêmement élevée, est formé par au moins deux résistors (R11, R12) connectés en série.

2. Procédé selon la revendication 1, dans lequel la branche de rebouclage (120) comprend un troisième résistor (R3) et un quatrième résistor (R4), dans lequel le troisième résistor et le quatrième résistor divisent une tension fournie en sortie par l'extrémité de sortie du convertisseur continu/continu (110), et fournissent en entrée une tension divisée à la seconde extrémité d'entrée du convertisseur continu/continu.

3. Procédé selon la revendication 2, dans lequel :

la première expression relationnelle est :

$$V\max = Vref\left(1 + \left(R3/R4\right)\right) + \left(Vref - Vpwm\left(\min\right)\right)\left(R3/\left(R1 + R2\right)\right)$$

dans laquelle Vmax est la valeur de tension de sortie maximale, Vref est la tension de référence, R1 est le premier résistor, R2 est le deuxième résistor, R3 est le troisième résistor, R4 est le quatrième résistor, et Vpwm(min) est la tension d'impulsion minimale ; et

la seconde expression relationnelle est

$$V\min = Vref\left(1 + \left(R3/R4\right)\right) + \left(Vref - Vpwm\left(\max\right)\right)\left(R3/\left(R1 + R2\right)\right)$$

dans laquelle Vmin est la valeur de tension de sortie minimale, et Vpwm(max) est la tension d'impulsion maximale.

4. Appareil destiné à déterminer des valeurs de résistance d'un circuit de réglage de tension dynamique, dans lequel le circuit de réglage de tension dynamique comprend : un convertisseur continu/continu (110), une branche de rebouclage (120), une branche d'entrée d'impulsion (130), et un modulateur d'impulsions en durée (140), dans lequel une première extrémité d'entrée du convertisseur continu/continu est configurée pour fournir en entrée une tension de référence (Vref), une seconde extrémité d'entrée du convertisseur continu/continu est configurée pour recevoir un signal rebouclé à travers la branche de rebouclage et un signal d'impulsion fourni en entrée par le modulateur d'impulsions en durée à travers la branche d'entrée d'impulsion, et une extrémité de sortie du convertisseur continu/continu fournit en sortie un signal au modulateur d'impulsions en durée, dans lequel le signal d'impulsion est utilisé pour compenser le signal de rebouclage, le convertisseur continu/continu compare le signal de rebouclage compensé par le signal d'impulsion avec la tension de référence pour régler le signal de sortie, et une relation linéaire entre le signal d'impulsion et le signal de sortie varie avec la tension de référence ; et

l'appareil est configuré pour déterminer, selon la tension de référence, des valeurs de résistance de résistors multiples dans la branche de rebouclage et la branche d'entrée d'impulsion pour déterminer la relation linéaire ; **caractérisé en ce que** l'appareil comprend : un module de détermination de tension (310), un module de détermination d'expression relationnelle (320), et un module de recherche de valeur de résistance (330), dans lequel

le module de détermination de tension (310) est configuré pour déterminer une tension de référence, une valeur de tension de sortie maximale, et une valeur de tension de sortie minimale du circuit de réglage de tension dynamique, dans lequel la valeur de tension de sortie maximale est une tension fournie en sortie par le circuit de réglage de tension dynamique lorsque le modulateur d'impulsions en durée fournit en entrée une tension d'impulsion minimale à travers la branche d'entrée d'impulsion, et la valeur de tension de sortie minimale est une tension fournie en sortie par le circuit de réglage de tension dynamique lorsque le modulateur d'impulsions en durée fournit en entrée une tension d'impulsion maximale à travers la branche d'entrée d'impulsion ; et le module de détermination de tension envoie la tension de référence, la valeur de tension de sortie maximale, et la valeur de tension de sortie minimale au module de détermination d'expression relationnelle ;

le module de détermination d'expression relationnelle (320) est configuré pour recevoir la tension de référence, la valeur de tension de sortie maximale et la valeur de tension de sortie minimale, déterminer, selon la tension de référence et la valeur de tension de sortie maximale, une première expression relationnelle entre la tension de référence, la valeur de tension de sortie maximale, et les résistors multiples, et déterminer, selon la tension de référence et la valeur de tension de sortie minimale, une seconde expression relationnelle entre la tension de référence, la valeur de tension de sortie minimale, et les résistors multiples ; et envoyer la première expression relationnelle et la seconde expression relationnelle au module de recherche de valeur de résistance ; et

le module de recherche de valeur de résistance (330) est configuré pour recevoir la première expression relationnelle et la seconde expression relationnelle, et déterminer, selon la première expression relationnelle et la seconde expression relationnelle, un groupe de valeurs de résistance des résistors multiples ;

dans lequel la branche d'entrée d'impulsion comprend un premier résistor (R1), un premier condensateur (C1) et un deuxième résistor (R2), dans lequel une extrémité du premier résistor est connectée à la seconde extrémité d'entrée du convertisseur continu/continu, l'autre extrémité du premier résistor est connectée à une extrémité à la fois du premier condensateur et du deuxième résistor, l'autre extrémité du premier condensateur est mise à la masse, et l'autre extrémité du deuxième résistor est connectée à une extrémité de sortie du modulateur d'impulsions en durée ; et le module de recherche de valeur de résistance est configuré pour fixer une valeur de résistance du deuxième résistor à une valeur fixe, et déterminer, selon la valeur de résistance du deuxième résistor, la première expression relationnelle et la seconde expression relationnelle, un groupe de valeurs de résistance, correspondant à la tension de référence, des résistors multiples ;

dans lequel le premier résistor (R1), qui doit fournir une résistance extrêmement élevée, est formé par au moins deux résistors (R11, R12) connectés en série.

5. Appareil selon la revendication 4, dans lequel la branche de rebouclage (120) comprend un troisième résistor (R3) et un quatrième résistor (R4), dans lequel le troisième résistor et le quatrième résistor divisent une tension fournie en sortie par l'extrémité de sortie du convertisseur continu/continu (110), et fournissent en entrée une tension divisée à la seconde extrémité d'entrée du convertisseur continu/continu.

6. Appareil selon la revendication 5, dans lequel :

la première expression relationnelle est :

$$V\max = Vref\left(1+\left(R3/R4\right)\right)+\left(Vref-Vpwm\left(\min\right)\right)\left(R3/\left(R1+R2\right)\right)$$

dans laquelle Vmax est la valeur de tension de sortie maximale, Vref est la tension de référence, R1 est le premier résistor, R2 est le deuxième résistor, R3 est le troisième résistor, R4 est le quatrième résistor, et Vpwm(min) est la tension d'impulsion minimale ; et la seconde expression relationnelle est

$$V\min = Vref\left(1+\left(R3/R4\right)\right)+\left(Vref-Vpwm\left(\max\right)\right)\left(R3/\left(R1+R2\right)\right)$$

dans laquelle Vmin est la valeur de tension de sortie minimale, et Vpwm(max) est la tension d'impulsion maximale.

120 110
Direct current/direct
current converter L Vout 140
Pulse width modulator

R3 Control
circuit PWM
signal CPU
Vref generator
R4 C2

PWM
R1 R2 ⎍⎍⎍⎍
C1 130

FIG. 1

S201

Determine a reference voltage, a maximum output voltage value, and a
minimum output voltage value of a dynamic voltage-adjusting circuit

S202

Determine, according to the reference voltage and the maximum output
voltage value, a first relational expression between the reference voltage,
the maximum output voltage value, and multiple resistors in a feedback
branch and a pulse input branch of the dynamic voltage-adjusting circuit,
and determine, according to the reference voltage and the minimum output
voltage value, a second relational expression between the reference voltage,
the minimum output voltage value, and the multiple resistors

S203

Determine, according to the first relational expression and the second
relational expression, a group of resistance values, corresponding to the
reference voltage, of the multiple resistors

FIG. 2

310

Voltage
determining
module

320

Relational
expression
determining
module

330

Resistance
value
searching
module

FIG. 3

420

Processor

460

Bus

410

Read-only
memory

Random access
memory

Output
device

440

Basic input/
output
system

Operating
system

Input device

430

450

Application
program

FIG. 4

**EP 2 930 834 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014103993 A

- US 2007090819 A

**Non-patent literature cited in the description**

- **BUIATTI G M et al.** An unified method for estimating the parameters of non-isolated DC/DC converters using continuous time model. *Telecommunications Energy Conference,* 2007, 334-341